# FASCICULE DE BREVET EUROPEEN

(11) **EP 4 084 045 B1**
(45) Date de publication et mention de la délivrance du brevet: **25.03.2026**
(21) Numéro de dépôt: 22170109.7
(22) Date de dépôt: 26.04.2022
(51) Int. Cl.: H01L 21/321, H01L 21/3115, H10D 48/30

(54) **PROCÉDÉ DE FORMATION DES ESPACEURS D'UNE GRILLE D'UN TRANSISTOR**
VERFAHREN ZUR BILDUNG VON ABSTANDHALTERN EINES GATES EINES TRANSISTORS
METHOD FOR FORMING SPACERS OF A TRANSISTOR GATE

(30) Priorité: 28.04.2021 FR 2104449
(43) Date de publication de la demande: 02.11.2022
(73) Titulaire: Commissariat à l'Energie Atomique et aux Energies Alternatives, 75015 Paris (FR)
(72) Inventeur: POSSEME, Nicolas, 38054 Grenoble Cedex 09 (FR); BACQUIE, Valentin, 38054 Grenoble Cedex 09 (FR)
(74) Mandataire: Hautier IP

(56) Documents cités:
- JP-A- 2003 282 885
- US-A1- 2016 300 709
- US-A1- 2017 084 720
- US-A1- 2017 338 157
- US-A1- 2019 164 776
- US-A1- 2020 135 467
- US-A1- 2020 251 569

## Description

### DOMAINE TECHNIQUE

La présente invention concerne en général les transistors à effet de champs (FET) utilisés par l'industrie de la microélectronique et plus particulièrement la réalisation des espaceurs de grille des transistors de type métal-oxyde-semiconducteur (MOSFET) majoritairement utilisés pour la production de toutes sortes de circuits intégrés.

### ETAT DE LA TECHNIQUE

La technologie à base de transistors Métal-Oxyde-Semiconducteur Complémentaires CMOS (de l'anglais « Complementary Metal Oxide Semiconductor »), basée sur l'utilisation de transistors MOSFET complémentaires de type n et de type p, utilise couramment des substrats de type SOI (de l'anglais « silicon on insulator ») pour accroître les performances des transistors.

Un substrat SOI, qui comprend une fine couche superficielle de silicium monocristallin dite topSi reposant sur une couche d'oxyde de silicium enterrée dite BOX (acronyme de l'anglais « buried oxide layer »), permet notamment de réduire drastiquement les capacités parasites des transistors. Cette couche est également qualifiée de couche active.

Pour améliorer encore les performances des transistors, il est avantageux que le canal du transistor dans le topSi puisse être complètement déserté de porteurs, c'est-à-dire « fully depleted » (FD), selon le vocable anglais dédié. Pour y parvenir, il est généralement nécessaire que le topSi soit très mince, typiquement d'épaisseur inférieure à 10 nm. Ce type de substrat est ainsi désigné par l'acronyme FDSOI.

Une telle épaisseur rend certaines étapes de fabrication des transistors critiques, notamment la formation des espaceurs sur les flancs latéraux de la grille des transistors.

Le document US2017/084720 décrit la réalisation d'un tel espaceur par la formation d'une couche diélectrique suivie d'une modification anisotrope des portions basales de la couche diélectrique par implantation d'ions. Le document JP2003282885 décrit la suppression des espèces à bases d'hydrogène dans une couche de SiGe grâce à un recuit à une température comprise entre 250 et 500°C.

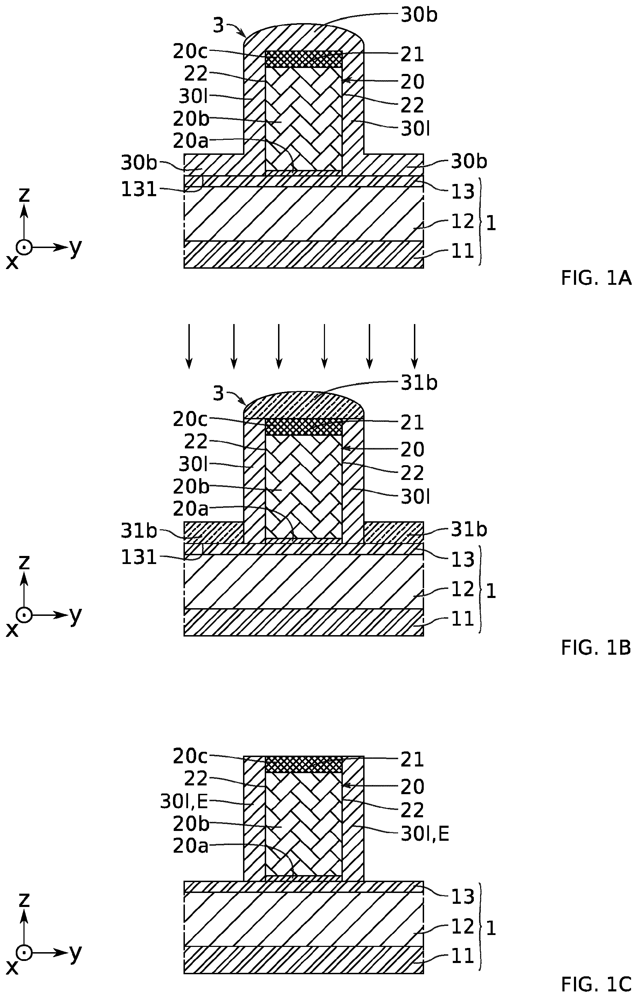

Comme illustré aux figures 1A, 1C, les espaceurs sont en effet typiquement formés par gravure anisotrope d'une couche diélectrique 3 recouvrant les grilles 20 des transistors. Cette gravure permet de graver des portions basales 30b de la couche diélectrique 3, qui s'étendent principalement de façon parallèle au plan de base du substrat 1, tout en conservant des portions latérales 30l de la couche diélectrique 3 qui s'étendent sur les flancs 22 latéraux de la grille 20. Ces dernières forment ainsi les espaceurs E de grille des transistors.

La gravure anisotrope doit ainsi permettre de retirer les portions basales 30b en exposant le topSi 13, sans endommager le topSi 13 et en conservant les portions latérales 30l.

L'arrêt de la gravure à l'interface 131 entre la couche diélectrique 3 et le topSi 13 est une problématique majeure de la formation des espaceurs.

Si la gravure est prolongée trop longtemps, le topSi peut être en partie consommé ou endommagé. Au contraire, si elle n'est pas suffisamment prolongée, les espaceurs peuvent présenter des pieds de gravure préjudiciables à la définition précise des dimensions critiques des espaceurs.

Pour éviter un compromis difficile à trouver entre ces deux conditions antagonistes lors de la gravure directe des portions basales, le document EP 3107125 B1 prévoit une étape préalable de modification des portions basales 30b par implantation d'ions légers (figure 1B), suivie d'une étape de retrait des portions basales modifiées 31b, sélectivement aux portions latérales non modifiées 30l (figure 1C). Cela permet de relâcher les contraintes sur l'arrêt de gravure. La précision de gravure est ainsi améliorée.

En pratique cependant, une telle solution ne s'avère pas optimale. La précision de gravure reste perfectible. Les performances des transistors peuvent encore être améliorées.

Un objet de la présente invention est de pallier les limitations des solutions connues.

Un autre objet de la présente invention est de proposer un procédé de fabrication d'espaceurs permettant une meilleure définition des dimensions critiques des espaceurs.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation on prévoit un procédé de formation des espaceurs d'une grille d'un transistor située sur une couche active en un matériau semi-conducteur. Le procédé comprend :
- une fourniture d'un empilement comprenant la couche active et la grille, ladite grille présentant un sommet et des flancs latéraux,
- une formation d'une couche diélectrique en un matériau diélectrique de base recouvrant la grille et au moins partiellement la couche active de part et d'autre de la grille, ladite couche diélectrique présentant des portions latérales recouvrant les flancs latéraux de la grille, et des portions basales recouvrant le sommet et la couche active, les portions basales présentant une épaisseur eb,
- une modification anisotrope des portions basales de ladite couche diélectrique par implantation d'ions à base d'hydrogène selon une direction Z parallèle aux flancs latéraux de la grille, ladite implantation étant réalisée selon toute l'épaisseur eb des portions basales, et au moins en partie dans la couche active, ladite modification anisotrope formant des premières portions basales modifiées à base d'un premier matériau diélectrique modifié et des portions latérales non modifiées à base du matériau diélectrique de base, puis
- un recuit configuré pour désorber les espèces à base d'hydrogène implantées dans la couche active, ledit recuit transformant les premières portions basales modifiées en des deuxièmes portions basales modifiées à base d'un deuxième matériau diélectrique modifié, puis
- un retrait des deuxièmes portions basales modifiées par gravure sélective du deuxième matériau diélectrique modifié vis-à-vis du matériau diélectrique de base et vis-à-vis du matériau semi-conducteur, de façon à former les espaceurs sur les flancs latéraux de la grille à partir des portions latérales non modifiées.

Avantageusement, la modification anisotrope des portions basales est configurée de sorte à ce que les ions à base d'hydrogène sont implantés selon toute l'épaisseur eb des portions basales, et au moins en partie dans la couche active.

Avantageusement, le procédé comprend en outre, après ladite modification anisotrope et avant le retrait des portions basales modifiées, un recuit configuré pour désorber les espèces à base d'hydrogène implantées dans la couche active. Ce recuit est en outre configuré pour désorber au moins 75%, voire au moins 90% et de préférence au moins 95%, des espèces à base d'hydrogène implantées dans les premières portions basales modifiées.

Dans le cadre du développement de la présente invention, il a été observé que l'arrêt précis de l'implantation d'ions légers à l'interface entre la couche diélectrique et la couche active est difficile à réaliser en pratique. Ainsi, le procédé divulgué par le document d'art antérieur EP 3107125 B1 présente des points de fonctionnement limités. Les gammes de paramètres de ce procédé selon l'art antérieur sont très restreintes. Cela limite fortement sa mise en œuvre pratique. Il apparaît que l'implantation d'ions légers est le plus souvent :
- soit pas suffisamment profonde pour modifier suffisamment les portions basales sur toute leur hauteur ; il est alors difficile de retirer les portions basales et les espaceurs ainsi obtenus présentent typiquement un pied de gravure,
- soit trop profonde et une partie de la couche active sous-jacente aux portions basales est également modifiée ; cette partie de couche active modifiée nuit aux performances des transistors.

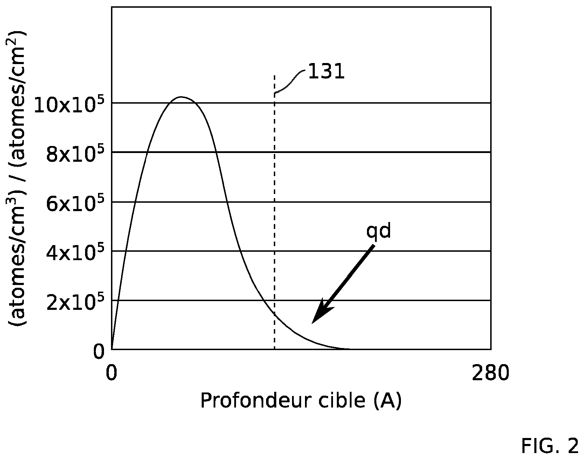

Contrairement aux solutions connues de l'art antérieur qui visent à supprimer l'implantation d'ions dans la couche active lors de la modification des portions basales, le procédé selon l'invention prévoit volontairement une implantation d'ions à base d'hydrogène jusque dans la couche active, sous l'interface 131 entre la couche diélectrique et la couche active, comme illustré à la figure 2. Toute l'épaisseur des portions basales est ainsi modifiée. Cela évite la formation d'un pied de gravure pour les espaceurs, lors du retrait des portions basales modifiées. Le contrôle en dimension des espaceurs est amélioré.

Il n'est donc plus nécessaire de contrôler précisément la profondeur d'implantation des ions à base d'hydrogène, dès lors que celle-ci est supérieure ou égale à l'épaisseur eb des portions basales.

Les contraintes sur la profondeur d'implantation sont donc avantageusement relâchées dans le procédé selon l'invention. En particulier il est possible d'élargir la gamme d'énergie d'implantation des ions à base d'hydrogène, par rapport au procédé de l'art antérieur. Cela facilite la mise en oeuvre du procédé.

Le procédé prévoit en outre une guérison de la couche active par un recuit permettant de désorber les ions à base d'hydrogène implantés sous l'interface entre la couche diélectrique et la couche active. La guérison peut uniquement consister à désorber les ions à base d'hydrogène, ou peut en supplément supprimer d'éventuels défauts cristallins occasionnés lors de l'implantation.

Ce recuit transforme les premières portions basales modifiées en deuxièmes portions basales modifiées. Les conditions de recuit et/ou le matériau diélectrique de base de la couche diélectrique sont choisis de sorte à conserver une sélectivité de gravure suffisante entre le deuxième matériau diélectrique modifié et le matériau diélectrique de base, de façon à retirer sélectivement les deuxièmes portions basales modifiées vis-à-à-vis des portions latérales non modifiées.

Le procédé selon l'invention permet ainsi de réaliser de façon avantageuse des espaceurs sans pied et sans dégrader la couche active sous-jacente.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
Les figures 1A à 1C illustrent schématiquement des étapes d'un procédé de formation d'espaceurs selon l'art antérieur.
La figure 2 illustre la distribution des ions légers selon un profil d'implantation de l'art antérieur.
Les figures 3A à 3D illustrent schématiquement des étapes d'un procédé de formation d'espaceurs selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches et portions, et les dimensions des motifs ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, à l'issue de la modification anisotrope par implantation, le matériau semi-conducteur de la couche active présente une concentration en hydrogène [H]a1, le recuit étant effectué de sorte qu'à l'issue du recuit la concentration en hydrogène [H]a2 est nulle ou inférieure à 0.05 * [H]a1, et de préférence inférieure à 0.02 * [H]a1.

Selon un exemple, le matériau diélectrique de base est choisi de façon à ce que le deuxième matériau diélectrique modifié présente une sélectivité à la gravure S ≥ 5:1 vis-à-vis du matériau diélectrique de base, et de préférence S ≥ 10:1.

Selon un exemple, le deuxième matériau diélectrique modifié présente, après le recuit de désorption, une sélectivité à la gravure S ≥ 5:1 vis-à-vis du matériau diélectrique de base, non modifié.

Selon un exemple, le matériau diélectrique de base de la couche diélectrique est à base de SiC.

Selon un exemple, avant la modification anisotrope par implantation d'ions à base d'hydrogène, le matériau diélectrique de base de la couche diélectrique est à base de SiCO.

Selon un exemple, à l'issue de la modification anisotrope par implantation d'ions à base d'hydrogène, le premier matériau diélectrique modifié est à base de SiOxHy, x et y étant des entiers naturels non nuls.

Selon un exemple, à l'issue du recuit, le deuxième matériau diélectrique modifié est à base de SiOx, x étant un entier naturel non nul.

Le couple des matériaux SiCO/SiOx présente avantageusement une bonne sélectivité de gravure. Le SiCO constitue donc un bon matériau diélectrique de base pour la mise en oeuvre du procédé selon l'invention. Ce n'est pas nécessairement le seul matériau pouvant être mis en oeuvre dans le procédé selon l'invention.

Selon un autre exemple, le matériau diélectrique de base de la couche diélectrique est à base de SiC amorphe ou de SiCN. Le procédé peut alors comprendre en outre une étape d'oxydation du premier matériau diélectrique modifié, après la modification anisotrope des portions basales, et de préférence avant le recuit.

Selon un exemple, le matériau semi-conducteur est à base de Si ou de SiGe.

Selon un exemple, le recuit est effectué à une température supérieure ou égale à 150°C. Cela permet d'augmenter la vitesse de désorption d'hydrogène.

Selon un exemple, le recuit est effectué à une température supérieure ou égale à 600°C. Cela permet en outre de réparer les défauts cristallins de la couche active, typiquement pour un matériau semi-conducteur en silicium.

Selon un exemple, le recuit est effectué pendant une durée t comprise entre 1min ≤ t ≤ 10 min.

Selon un exemple, le retrait des deuxièmes portions basales modifiées se fait par gravure humide à base d'une solution comprenant de l'acide fluorhydrique (HF). La gravure humide par HF du SiOx est sélective vis-à-vis du SiCO. Au contraire, une gravure par plasma HF ne permet pas un retrait des deuxièmes portions basales modifiées sélectivement aux portions latérales non modifiées, pour ce couple de matériaux SiOx /SiCO.

Selon un exemple, la formation de la couche diélectrique est configurée de façon à ce que ladite couche diélectrique soit conforme et présente une épaisseur constante égale à eb.

Selon un exemple, la modification anisotrope par implantation est effectuée dans un réacteur de gravure.

Selon un exemple, l'implantation anisotrope est effectuée par plasma à couplage inductif à partir d'une espèce hydrogénée de préférence prise parmi le dihydrogène (H2), le bromure d'hydrogène (HBr) et l'ammoniac (NH3).

Selon un exemple, le plasma est formé en utilisant au moins une espèce X favorisant la dissociation de l'espèce hydrogénée pour former lesdits ions à base d'hydrogène, ladite au moins une espèce X étant prise parmi l'argon, l'azote, le xénon, l'hélium.

Selon un exemple, les ions à base d'hydrogène sont implantés avec une énergie d'implantation supérieure à 150 eV et/ou inférieure à 300 eV. Cela permet d'implanter suffisamment profondément les ions à base d'hydrogène, notamment sur toute l'épaisseur eb d'une couche diélectrique à base de SiCO de quelques nanomètres à quelques dizaines de nanomètres. La gamme d'énergie des ions à base d'hydrogène exploitable dans le cadre de la présente invention est en outre très supérieure à celle de l'art antérieur. Cela permet de faciliter la mise en œuvre du procédé. Le fait de mettre en œuvre un recuit de désorption et/ou de guérison post implantation permet de relâcher les contraintes sur l'énergie d'implantation.

Selon un exemple, les ions à base d'hydrogène sont pris parmi H+, H2+, H3+.

Selon un exemple, la grille est un motif de grille sacrificielle utilisé dans un procédé dit « gate last », où le motif de grille sacrificielle est remplacé par une grille fonctionnelle après formation des espaceurs.

Selon un exemple, le transistor est un transistor de type FDSOI. De préférence, le procédé comprend après retrait des deuxièmes portions basales modifiées de part et d'autre de la grille, une étape de formation de zones de source et drain surélevés à partir de la couche active en un matériau semi-conducteur, par exemple par épitaxie.

Avantageusement, le matériau semi-conducteur est du silicium. Le matériau semi-conducteur peut également être du germanium (Ge) ou du silicium-germanium SiGe. L'étape de retrait des duxièmes portions basales modifiées peut être effectuée par gravure humide sélectivement au Ge ou au SiGe et/ou à de l'oxyde de SiGe ou de l'oxyde de Ge.

Selon un exemple, le recuit est configuré de sorte que le deuxième matériau diélectrique modifié puisse être gravé de manière sélective vis-à-vis du matériau diélectrique de base, non modifié.

Selon un exemple, le matériau diélectrique est pris parmi : le SiCO, le SiC, le SiOCN, le SiOCH.

Avantageusement, le retrait des deuxièmes portions basales modifiées se fait par gravure sélective du deuxième matériau diélectrique modifié vis-à-vis du matériau diélectrique de base, c'est-à-dire non modifié, et vis-à-vis du matériau semi-conducteur.

Selon un mode de réalisation, la gravure sélective du deuxième matériau diélectrique modifié est une gravure humide à l'aide d'une solution à base d'acide fluorhydrique (HF).

Sauf incompatibilité, il est entendu que l'ensemble des caractéristiques optionnelles ci-dessus peuvent être combinées de façon à former un mode de réalisation qui n'est pas nécessairement illustré ou décrit. Un tel mode de réalisation n'est évidemment pas exclu de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

Dans la présente invention, les portions latérales non modifiées peuvent comprendre superficiellement une faible concentration d'ions à base d'hydrogène, dans la mesure où il existe toujours en pratique une faible déflexion des ions vis-à-vis de la direction d'implantation ciblée. Cette faible concentration n'est typiquement pas suffisante pour modifier « suffisamment » le matériau diélectrique, c'est-à-dire de sorte à ce qu'il puisse être gravé ensuite. En outre, cette couche superficielle des portions latérales est généralement de très faible épaisseur, par exemple au moins 10 fois inférieure à l'épaisseur des portions latérales, de sorte que les portions latérales comprennent toujours le matériau diélectrique non modifié stricto sensu. Dans la présente demande, les portions latérales non modifiées désignent ainsi au moins les portions latérales comprenant le matériau diélectrique non modifié stricto sensu, et éventuellement cette couche superficielle faiblement modifiée.

Dans la présente demande de brevet, les termes « concentration », « taux » et « teneur » sont synonymes.

Plus particulièrement, une concentration peut être exprimée en unité relative telle que les fractions molaires ou massiques (%w).

Dans la suite, les concentrations sont des fractions molaires exprimées en %, sauf mention contraire.

Dans la suite, les valeurs de pression sont exprimées en Torr ou milliTorr, qui est l'unité usuellement utilisée par l'homme du métier. On rappelle que 1 Torr = 133,322 Pa.

On entend par « désorber » ou « désorption » des espèces d'un matériau, un phénomène de diffusion desdites espèces en dehors du matériau considéré. Le terme « désorber » peut signifier que les espèces ont diffusé entièrement en dehors du matériau, ou au moins partiellement de façon à ce que la concentration résiduelle d'espèces hydrogène [H]mr soit inférieure à au moins 50% de la concentration en hydrogène implanté [H]m, de préférence inférieure à au moins 70% de [H]m, de préférence inférieure à au moins 80% de [H]m, et de préférence inférieure à au moins 90% de [H]m.

Dans le cadre de la présente invention, le recuit permettant de désorber les espèces à base d'hydrogène est également dénommé recuit de désorption. Ce recuit de désorption est notamment configuré pour désorber les espèces à base d'hydrogène implantées dans la couche active et au moins 75%, voire au moins 90% et de préférence au moins 95%, des espèces à base d'hydrogène implantées dans les premières portions basales modifiées. Un tel recuit de désorption est donc spécifiquement configuré pour désorber les espèces à base d'hydrogène et ne peut pas être assimilé à n'importe quel recuit. En particulier, un recuit de séchage visant à évaporer l'eau en surface d'une plaque (wafer en anglais), typiquement effectué à une température de l'ordre de 100°C, ne permet pas de désorber les espèces à base d'hydrogène comme envisagé dans la présente invention. Un recuit de séchage n'est pas assimilable à un recuit de désorption tel qu'envisagé dans la présente invention.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants. Ainsi, une couche à base de silicium s'entend par exemple d'une couche Si, Si dopé n, Si dopé p, SiGe. Une couche à base de germanium s'entend par exemple d'une couche Ge, Ge dopé n, Ge dopé p, SiGe.

Le mot « diélectrique » qualifie un matériau dont la conductivité électrique est suffisamment faible dans l'application donnée pour servir d'isolant. Dans la présente invention, un matériau diélectrique présente de préférence une constante diélectrique inférieure à 7. Le matériau diélectrique modifié est réputé différent du matériau diélectrique non modifié. En particulier, le premier matériau diélectrique modifié est différent du matériau diélectrique de base. Le deuxième matériau diélectrique modifié est différent du premier matériau diélectrique modifié et du matériau diélectrique de base.

En général, mais non limitativement, un espaceur forme une bague autour de la grille, avec un contour fermé ; on pourrait donc parler d'un espaceur unique autour de la grille; cependant, les représentations en coupe, et les directions privilégiées des grilles, font que l'on parle aussi de paires d'espaceurs (ou premier et deuxième espaceurs), terminologie ici retenue.

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche présente typiquement une épaisseur selon z. Les termes relatifs « sur », « surmonte », « sous », « sous-jacent » se réfèrent à des positions prises selon la direction z.

Les termes « vertical », « verticalement » se réfèrent à une direction selon z. Les termes « horizontal », « horizontalement » se réfèrent à une direction dans le plan xy. Le terme « latéral » se réfère à un plan xz. Ainsi, les flancs latéraux de la grille s'étendent parallèlement à un plan xz.

Un élément situé « à l'aplomb » ou « au droit d'» un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

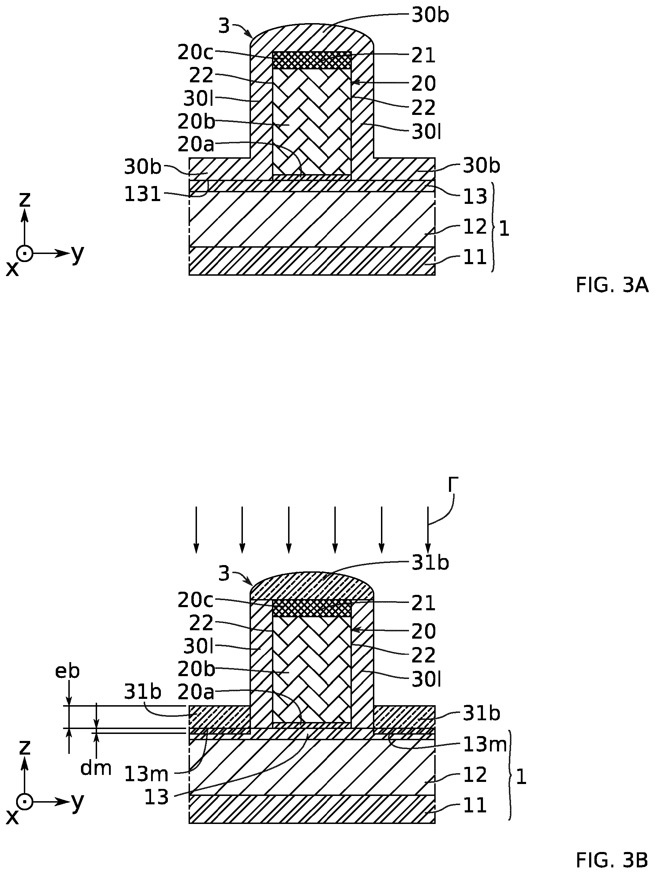

Les figures 3A à 3D illustrent un mode de réalisation du procédé selon l'invention. Selon ce mode de réalisation, une structure initiale illustrée en figure 3A est fournie.

Cette structure peut typiquement comprendre un substrat 1 comprenant une couche active 13 semi-conductrice à base de silicium ou de germanium. Cette couche active 13 présente typiquement une épaisseur de l'ordre de quelques nanomètres, par exemple 6 nm à 8 nm.

Le substrat 1 peut comprendre un support 11 massif dit « bulk », surmonté par une couche 12 isolante électriquement, typiquement une couche d'oxyde dite « BOX ».

Le support 11, la couche isolante 12 et la couche active 13 peuvent former un substrat 1 de type semi-conducteur sur isolant, par exemple un substrat silicium sur isolant SOI (acronyme de l'anglais « silicon on insulator) ou un substrat germanium sur isolant GeOI (acronyme de l'anglais « germanium on insulator), ou encore un substrat silicium sur isolant complétement déserté FDSOI (acronyme de l'anglais « fully depleted silicon on insulator).

La couche active 13 est surmontée d'un motif de grille ou grille 20.

De manière classique, ce motif de grille 20 peut présenter successivement les éléments suivants disposés à partir de la couche active 13 : une couche d'oxyde d'interface 20a ou une couche d'oxyde d'hafnium présentant une haute constante diélectrique, dite high k, une grille polysilcium 20b et un masque dur 20c.

Le motif de grille 20 présente typiquement une hauteur selon Z de plusieurs dizaines de nanomètres à plusieurs centaines de nanomètres.

Dans la suite de la description, et par souci de concision, le motif de grille sera désigné par la suite grille 20.

Comme illustré à la figure 3A, une couche diélectrique 3 en un matériau diélectrique, de préférence en SiCO, recouvre la grille 20 et la couche active 13 semi conductrice. L'épaisseur eb de cette couche diélectrique 3 est de préférence sensiblement constante. Elle peut être comprise entre 5 nm et 20 nm, de préférence entre 7 nm et 12 nm.

Cette couche diélectrique 3 est par exemple formée par l'une des techniques suivantes: dépôt chimique en phase vapeur (CVD, acronyme de chemical vapor deposition), dépôt chimique en phase vapeur assisté par plasma (PECVD, acronyme de plasma enhanced chemical vapor deposition), dépôt chimique en phase vapeur à basse pression (LPCVD, acronyme de low pressure CVD), dépôt par couche atomique assistée par plasma (PEALD, acronyme de plasma enhanced atomic layer deposition).

Cette couche diélectrique 3 comprend une portion latérale 30l sur chacun des flancs latéraux 22 de la grille 20, des portions basales 30b en surface du substrat 1 de part et d'autre de la grille 20, au contact de la couche active 13, et une portion basale 30b au sommet 21 de la grille 20. Les portions latérales 30l s'étendent selon des plans perpendiculaires au plan XY et les portions basales 30b s'étendent selon des plans parallèles au plan XY.

Le matériau diélectrique « de base » envisagé pour la formation d'espaceurs dans le cadre de la présente invention est préférentiellement à base de SiC ou de SiCO, poreux ou non poreux. Ce matériau requiert une stratégie de gravure spécifique. En particulier, les procédés de gravure classiques fluorocarbonés, par exemple à base d'une chimie CH3F/He/O2, modifient les propriétés diélectriques d'un tel matériau et ne sont pas envisageables pour la formation d'espaceurs.

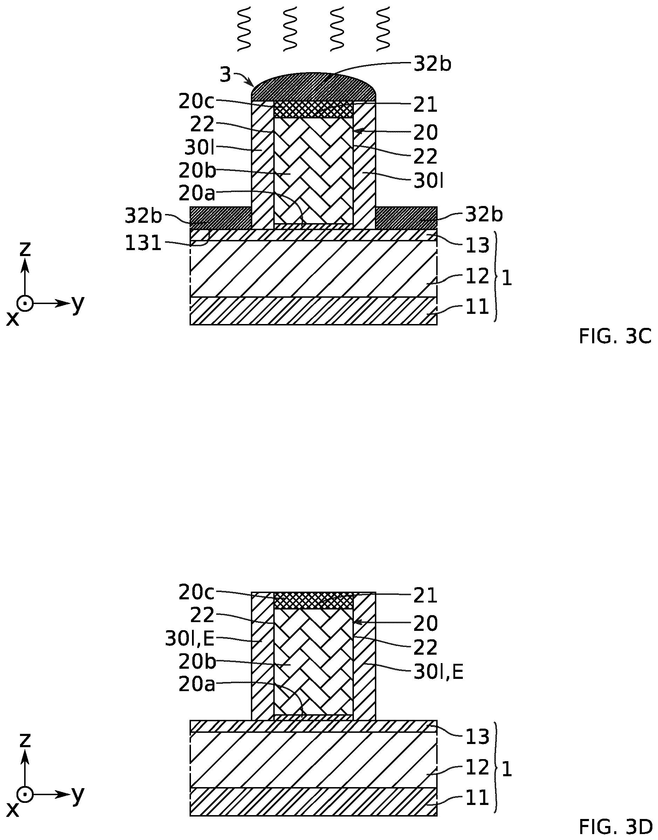

La stratégie de gravure mise en œuvre dans ce procédé comprend une première modification du matériau diélectrique par implantation, comme illustrée à la figure 3B, un recuit entraînant une deuxième modification du matériau diélectrique, comme illustrée à la figure 3C, puis une phase de retrait de ce deuxième matériau diélectrique modifié sélectivement au matériau diélectrique non modifié, comme illustré à la figure 3D. Une telle stratégie est avantageusement compatible avec l'utilisation de SiC ou de SiCO.

En particulier, le SiCO est modifié en SiOxHy lors de l'implantation d'ions à base d'hydrogène. Le SiOxHy est alors transformé en SiOx lors du recuit suivant. Le SiOx présente une bonne sélectivité de gravure vis-à-vis du SiCO, typiquement lors d'une gravure humide à base de HF. La phase de retrait du SiOx peut donc être effectuée sélectivement au SiCO.

Ce n'est pas le cas par exemple du nitrure de silicium (SiN) qui est classiquement utilisé comme matériau diélectrique pour former des espaceurs. Le SiN modifié à l'issue de l'implantation d'ions à base d'hydrogène tend en effet à revenir à son état initial non modifié, lors du recuit. Le retrait sélectif ne peut alors plus être effectué. Le SiN n'est donc pas un matériau envisagé dans le cadre de la mise en œuvre du procédé selon la présente invention.

Le SiCO peut être déposé directement sur la grille 20 et la couche active 13, par exemple par CVD. Un SiCO formé in situ, à partir d'un dépôt de SiC, suivi d'une oxydation, par exemple par plasma à base d'O2 ou par remise à l'air, n'est pas une solution retenue dans le cadre de la présente invention. Le SiCO est ici un matériau déposé et non un SiC modifié par un plasma d'O2.

Les étapes de modification anisotrope, recuit et retrait sélectif sont détaillées dans la suite, en regard respectivement des figures 3B, 3C, 3D.

Comme illustré à la figure 3B, la modification anisotrope des portions basales 30b est effectuée par implantation d'ions à base d'hydrogène. L'énergie d'implantation Γ est choisie de façon à modifier les portions basales 30b sur toute leur épaisseur eb. Des premières portions basales modifiées 31b d'épaisseur eb sont ainsi obtenues. Dans le cadre de l'invention, l'implantation est de préférence réalisée au sein d'un réacteur de gravure.

En revanche, cette modification anisotrope ne modifie pas les portions latérales 30l situées sur les flancs 22 de la grille 20, ces portions latérales 30l étant masquées par la portion basale 30B située au sommet 21 de la grille 20.

On choisira de préférence une énergie d'implantation supérieure ou égale à 150 eV, par exemple de l'ordre de 200eV à 300eV. Cela permet d'obtenir une implantation très directionnelle selon Z. La résolution spatiale d'implantation entre les portions basales 30b implantées et les portions latérales 30l non implantées est améliorée. Le contrôle des dimensions critiques des espaceurs est ainsi amélioré.

Par ailleurs, une telle énergie d'implantation permet de modifier les portions basales 30b sur toute leur épaisseur eb. Une partie 13m de la couche active 13 sous-jacente est également implantée par les ions à base d'hydrogène.

La figure 2 illustre un profil d'implantation obtenu par simulation de type SRIM (acronyme de « stopping and range of ions in matter » signifiant arrêt et répartition des ions dans la matière), pour une énergie d'implantation de 300 eV. Ce profil d'implantation présente une queue de distribution qd qui s'étend au-delà l'interface 131 entre les premières portions basales modifiées de la couche diélectrique et la couche active 13. Cette queue de distribution correspond à la partie 13m du matériau semi-conducteur modifié. Elle peut s'étendre sur une profondeur dm supérieure ou égale à 3 nm et de préférence supérieure ou égale à 5 nm, voire supérieure ou égale 10 nm. Elle peut s'étendre sur une profondeur dm de quelques nanomètres, par exemple 3 nm à 5 nm, en fonction des conditions d'implantation et des matériaux mis en œuvre.

Les conditions d'implantation peuvent être déterminées par simulation à l'aide d'un outil de simulation de type SRIM (stopping and range of ions in matter) ou TRIM (acronyme de « transport of ions in matter » signifiant transport des ions dans la matière).

Un autre paramètre influant sur la dose totale d'ions à base d'hydrogène implantés est la durée t pendant laquelle l'énergie d'implantation Γ est maintenue durant la phase de modification anisotrope.

Cette durée t peut varier de quelques secondes à quelques centaines de secondes, en fonction de la profondeur d'implantation visée et des matériaux utilisés.

La durée t de la modification anisotrope peut être d'environ 60s pour modifier une épaisseur de SiCO de 10nm.

L'implantation des ions à base d'hydrogène peut être effectuée dans un implanteur ou, de préférence, à partir d'un plasma.

Dans ce dernier cas, on pourra utiliser un réacteur plasma à couplage capacitif (CCP) ou un réacteur plasma à couplage inductif (ICP), ou un plasma par immersion.

Selon un mode de réalisation, le plasma utilisé est formé à partir d'un gaz comprenant au moins un premier composant gazeux hydrogéné noté H non carboné dont la dissociation génère lesdits ions à base d'hydrogène et, de façon optionnelle uniquement, un deuxième composant gazeux X comprenant au moins une espèce favorisant la dissociation du premier composant H pour former lesdits ions à base d'hydrogène.

Le premier composant H est de préférence choisi parmi le dihydrogène (H2), le silane (SiH4), l'ammoniac (NH3) ou le bromure d'hydrogène (HBr). Le deuxième composant X est de préférence choisi parmi l'hélium (He), le diazote (N2), l'argon (Ar) ou le xénon (Xe).

De préférence le débit du premier composant H est compris entre 10 et 500 sccm (centimètre cube par minute). Le débit du deuxième composant X est de préférence compris entre 10 et 500 sccm.

L'ajout d'un deuxième composant agissant comme un gaz de dissociation (tel que l'argon, l'hélium, le xénon, l'azote), peut notamment faciliter la dissociation du premier composant et favoriser ainsi l'implantation dudit premier composant dissocié dans la couche diélectrique. Il en résulte que la dose implantée est plus élevée. Le deuxième composant doit être néanmoins ajouté en faibles proportions, pour éviter un risque de pulvérisation de la couche diélectrique par des ions issus dudit deuxième composant. Ainsi, on choisira un ratio de gaz entre le premier composant et le deuxième composant compris entre 1 :19 et 19 :1, voire entre 1 :9 et 9 :1, voire entre 1 :5 et 5 :1.

L'implantation par plasma est configurée de façon à modifier la couche diélectrique 3 sans pour autant la pulvériser.

Les paramètres supplémentaires suivants peuvent être réglés pour la phase de modification anisotrope par implantation par plasma :
- la pression régnant à l'intérieur de la chambre du réacteur plasma. De préférence, cette pression est comprise entre 5 milliTorr et 100 milliTorr (soit entre 0,666 Pa.et 13,332 Pa), typiquement de l'ordre de 10 milliTorr.(1,333.Pa) Cela permet d'éviter une implantation isotrope ;
- la température est de préférence inférieure à 100°C, afin de modifier efficacement la couche diélectrique 3 ;
- La tension de polarisation (bias) du plasma varie typiquement entre 20V et 300V ;
- la puissance de la source plasma peut être réglée de façon à obtenir un flux ionique plus ou moins important. On choisira typiquement une puissance source comprise entre 0W et 2000W.
- la source plasma ou, de préférence, le bias peuvent être pulsés, avec une fréquence comprise entre 100 Hz à 5 kHz. On choisira typiquement un rapport cyclique de 10% à 90% pour réduire l'énergie ionique.

Ces paramètres peuvent être ajustés en fonction de la nature des portions basales à graver et de l'épaisseur eb.

Selon un mode de réalisation, la modification anisotrope pour modifier 10nm de SiCO est effectuée avec les paramètres suivants : Pression = 10 mtorr / Tension RF de polarisation = 250 V / durée t =60s / débit He = 250 sccm / débit CH4 = 10 sccm / Puissance RF = 250W.

Comme illustré à la figure 3C, la modification anisotrope des portions basales est suivie d'un recuit. Ce recuit est configuré pour retirer par désorption l'hydrogène implanté dans les parties 13m de la couche active 13. Ce recuit peut également guérir ou réparer ces portions 13m de manière à obtenir une couche active 13 non dégradée.

Le recuit a en outre pour effet de transformer les premières portions basales modifiées 31b en deuxièmes portions basales modifiées 32b.

Ce recuit se fait typiquement à une température supérieure ou égale à 150°C pour désorber l'hydrogène implantées dans les parties 13m de la couche active 13. Il peut éventuellement être effectué à plus haute température, par exemple à une température de l'ordre de 600°C, pour réparer les défauts cristallins du matériau semi-conducteur, qui auraient pu être occasionnés lors de l'implantation.

Le recuit peut se faire selon un procédé rapide connu de type RTA (acronyme de Rapid Thermal Annealing). D'autres procédés de recuit peuvent cependant être envisagés. Une rampe de température et/ou un pic en température peuvent être appliqués pendant la durée du recuit. La durée du recuit est typiquement comprise entre quelques dizaines de secondes et quelques minutes, par exemple 5 min.

A l'issue du recuit, la couche active 13 a sensiblement retrouvé son intégrité sur toute son épaisseur, les portions 13m modifiées par implantation ont disparues, et les premières portions basales modifiées 31b deviennent des deuxièmes portions basales modifiées 32b, comme illustré à la figure 3C.

Le retrait sélectif des deuxièmes portions basales modifiées peut être effectué par gravure selon plusieurs variantes de réalisation. Des chimies de gravure sèches ou humides peuvent être utilisées.

Selon un mode de réalisation, le retrait des deuxièmes portions basales modifiées 32b est effectué par gravure humide sélective au matériau semi-conducteur de la couche active 13. Si le matériau semi-conducteur est du silicium, alors le retrait des portions 32b modifiées est effectué par gravure humide sélectivement au silicium (Si).

De préférence, la gravure sélective au silicium est obtenue à l'aide d'une solution à base d'acide fluorhydrique (HF). Par exemple, pour éliminer 10 nm de SiOx, une solution HF 1% pendant 40s peut être utilisée.

A titre d'exemple pour une couche diélectrique 3 en SiCO, avec une solution à base d'acide fluorhydrique (HF) dilué à 1%, la vitesse de gravure du SiOx (matériau diélectrique modifié) est de l'ordre de 6 nm/min, alors que la vitesse de gravure du SiCO (matériau diélectrique non modifié) est quasi nulle.

Cela permet de retirer entièrement les portions 32b modifiées sans consommer les portions latérales 30l non modifiées sur les flancs 22 de la grille 20, ni consommer la couche active 13.

Les performances des transistors sont ainsi préservées.

Selon un autre mode de réalisation, le retrait des deuxièmes portions basales modifiées est effectué par gravure sèche sélective au matériau semiconducteur. Une chimie de gravure polymérisante fluorocarbonnée ou hydrofluorocarbonnée de type CHxFy, avec x et y entier, peut par exemple être mise en œuvre lors de cette gravure sèche.

Après retrait des deuxièmes portions basales 32b modifiées, les espaceurs E sont typiquement formés par les portions latérales 30l non modifiées (figure 3D). Le procédé permet avantageusement de réaliser des espaceurs E pour des transistors MOSFET.

L'invention n'est cependant pas limitée aux modes de réalisations précédemment décrits.

## Revendications

1. Procédé de formation d'au moins un espaceur (E) d'une grille (20) d'un transistor située sur une couche active (13) en un matériau semi-conducteur, comprenant :
- Une fourniture d'un empilement comprenant la couche active (13) et la grille (20), ladite grille (20) présentant un sommet (21) et des flancs latéraux (22),
- une formation d'une couche diélectrique (3) en un matériau diélectrique de base recouvrant la grille et au moins partiellement la couche active (13) de part et d'autre de la grille (20), ladite couche diélectrique (3) présentant des portions latérales (30l) recouvrant les flancs latéraux (22) de la grille, et des portions basales (30b) recouvrant le sommet (21) et la couche active (13), les portions basales (30b) présentant une épaisseur eb,
- une modification anisotrope des portions basales (30b) de ladite couche diélectrique (3) par implantation d'ions à base d'hydrogène selon une direction (Z) parallèle aux flancs latéraux (22) de la grille (20), ladite implantation étant réalisée selon toute l'épaisseur eb des portions basales (30b), et au moins en partie dans la couche active (13, 13m), ladite modification anisotrope formant des premières portions basales modifiées (31b) à base d'un premier matériau diélectrique modifié et des portions latérales (30l) non modifiées à base du matériau diélectrique de base, puis
- un recuit configuré pour désorber les espèces à base d'hydrogène implantées dans la couche active (13, 13m) et au moins 75% des espèces à base d'hydrogène implantées dans les premières portions basales modifiées (31b), ledit recuit transformant les premières portions basales modifiées (31b) en des deuxièmes portions basales modifiées (32b) à base d'un deuxième matériau diélectrique modifié, puis
- un retrait des deuxièmes portions basales modifiées (32b) par gravure sélective du deuxième matériau diélectrique modifié vis-à-vis du matériau diélectrique de base et vis-à-vis du matériau semi-conducteur, de façon à former l'au moins un espaceur (E) sur les flancs latéraux (22) de la grille à partir des portions latérales (30l) non modifiées.

2. Procédé selon la revendication précédente dans lequel le matériau diélectrique de base est choisi de façon à ce que le deuxième matériau diélectrique modifié présente une sélectivité à la gravure S ≥ 5:1 vis-à-vis dudit matériau diélectrique de base, et de préférence S ≥ 10:1.

3. Procédé selon l'une quelconque des revendications précédentes dans lequel le matériau diélectrique de base est à base de SiC.

4. Procédé selon l'une quelconque des revendications précédentes dans lequel, avant la modification anisotrope par implantation d'ions à base d'hydrogène, le matériau diélectrique de base est à base de SiCO et, à l'issue de la modification anisotrope par implantation d'ions à base d'hydrogène, le premier matériau diélectrique modifié est à base de SiOxHy, et, à l'issue du recuit, le deuxième matériau diélectrique modifié est à base de SiOx, x et y étant des entiers naturels non nuls.

5. Procédé selon l'une quelconque des revendications précédentes dans lequel le recuit est effectué à une température supérieure ou égale à 150°C ou à une température supérieure ou égale à 600°C.

6. Procédé selon l'une quelconque des revendications précédentes dans lequel le recuit est effectué pendant une durée t comprise entre 1min ≤ t ≤ 10 min.

7. Procédé selon l'une quelconque des revendications précédentes dans lequel le retrait des deuxièmes portions basales modifiées (32b) se fait par gravure humide à base d'une solution comprenant de l'acide fluorhydrique (HF).

8. Procédé selon l'une quelconque des revendications précédentes dans lequel la modification anisotrope est effectuée par plasma à couplage inductif à partir d'une espèce hydrogénée, de préférence prise parmi le dihydrogène (H2), le bromure d'hydrogène (HBr) et l'ammoniac (NH3).

9. Procédé selon la revendication précédente dans lequel le plasma est formé en utilisant au moins une espèce X favorisant la dissociation de l'espèce hydrogénée pour former lesdits ions à base d'hydrogène, ladite au moins une espèce X étant prise parmi l'argon, l'azote, le xénon, l'hélium.

10. Procédé selon l'une quelconque des revendications précédentes dans lequel les ions à base d'hydrogène sont implantés avec une énergie d'implantation supérieure à 150 eV et/ou inférieure à 300 eV.

11. Procédé selon l'une quelconque des revendications précédentes dans lequel à l'issue de la modification anisotrope par implantation, le matériau semi-conducteur de la couche active (13) présente une concentration en hydrogène [H]a1, le recuit étant effectué de sorte qu'à l'issue du recuit la concentration en hydrogène [H]a2 est nulle ou inférieure à 0.05 * [H]a1, et de préférence inférieure à 0.02 * [H]a1.

12. Procédé selon l'une quelconque des revendications précédentes dans lequel la modification anisotrope par implantation est effectuée dans un réacteur de gravure.

13. Procédé selon l'une quelconque des revendications précédentes dans lequel le recuit est configuré pour désorber au moins 90% des espèces à base d'hydrogène implantées dans les premières portions basales modifiées (31b).

14. Procédé selon l'une quelconque des revendications précédentes dans lequel le recuit est configuré pour désorber au moins 95% des espèces à base d'hydrogène implantées dans les premières portions basales modifiées (31b).

## Patentansprüche

1. Verfahren zum Bilden mindestens eines Abstandhalters (E) eines Gates (20) eines Transistors, der sich auf einer aktiven Schicht (13) aus einem Halbleitermaterial befindet, das Folgendes umfasst:
- Bereitstellen einer Stapelung, die die aktive Schicht (13) und das Gate (20) umfasst, wobei das Gate (20) einen Scheitel (21) und Seitenflanken (22) aufweist,
- ein Bilden einer dielektrischen Schicht (3) aus einem dielektrischen Basismaterial, das das Gate und mindestens teilweise die aktive Schicht (13) zu beiden Seiten des Gates (20) abdeckt, wobei die dielektrische Schicht (3) Seitenteile (30l) aufweist, die die Seitenflanken (22) des Gates abdecken, und Basisteile (30b), die den Scheitel (21) und die aktive Schicht (13) abdecken, wobei die Basisteile (30b) eine Dicke eb aufweisen,
- eine anisotrope Modifikation der Basisteile (30b) der dielektrischen Schicht (3) durch Ionenimplantation auf Wasserstoffbasis gemäß einer Richtung (Z) parallel zu den Seitenflanken (22) des Gitters (20), wobei die Implantation gemäß der gesamten Dicke eb der Basisteile (30b) und mindestens zum Teil in der aktiven Schicht (13, 13m) erfolgt, wobei die anisotrope Modifikationen erste modifizierte Basisteile (31b) auf Basis eines ersten modifizierten dielektrischen Materials und nicht modifizierte Seitenteile (30l) auf Basis des dielektrischen Basismaterial bilden, dann
- ein Tempern, das dazu konfiguriert ist, die Spezies auf Basis von Wasserstoff, die in der aktiven Schicht (13, 13m) implantiert sind und mindestens 75 % der Spezies auf Basis von Wasserstoff, die in den ersten modifizierten Basisteilen (31b) implantiert sind, zu desorbieren, wobei das Tempern die ersten modifizierten Basisteile (31b) in zweite modifizierte Basisteile (32b) auf Basis eines zweiten modifizierten dielektrischen Materials umwandelt, dann
- ein Entfernen der zweiten modifizierten Basisteile (32b) durch selektives Ätzen des zweiten modifizierten dielektrischen Materials gegenüber dem dielektrischen Basismaterial und gegenüber dem Halbleitermaterial derart, dass mindestens ein Abstandhalter (E) auf den Seitenflanken (22) des Gates ausgehend von den nicht modifizierten Seitenteilen (30l) gebildet wird.

2. Verfahren nach dem vorstehenden Anspruch, wobei das dielektrische Basismaterial derart ausgewählt wird, dass das zweite modifizierte dielektrische Material eine Ätzselektivität S > 5:1 und bevorzugt S > 10:1 gegenüber dem dielektrischen Basismaterial aufweist.

3. Verfahren nach einem der vorstehenden Ansprüche, wobei das dielektrische Basismaterial auf SiC basiert.

4. Verfahren nach einem der vorstehenden Ansprüche, wobei vor der anisotropen Modifikation durch Ionenimplantation auf Basis von Wasserstoff das dielektrische Basismaterial auf SiCO basiert, und nach der anisotropen Modifikation durch Ionenimplantation auf Basis von Wasserstoff das erste modifizierte dielektrische Material auf SiOxHy basiert, und nach dem Tempern das zweite modifizierte dielektrische Material auf SiOx basiert, wobei x und y natürliche Ganzzahlen ungleich null sind.

5. Verfahren nach einem der vorstehenden Ansprüche, wobei das Tempern bei einer Temperatur größer oder gleich 150 °C oder bei einer Temperatur größer oder gleich 600 °C erfolgt.

6. Verfahren nach einem der vorstehenden Ansprüche, wobei das Tempern während einer Dauer t zwischen 1 min < t < 10 min erfolgt.

7. Verfahren nach einem der vorstehenden Ansprüche, wobei das Entfernen der zweiten modifizierten Basisteile (32b) durch Nassätzen mit einer Lösung auf Basis von Flusssäure (HF) erfolgt.

8. Verfahren nach einem der vorstehenden Ansprüche, wobei die anisotrope Modifikation durch induktiv gekoppeltes Plasma ausgehend von einer hydrierten Spezies, bevorzugt ausgewählt aus Dihydrogen (H2), Bromwasserstoff (HBr) und Ammoniak (NH3), erfolgt.

9. Verfahren nach dem vorstehenden Anspruch, wobei das Plasma unter Verwendung mindestens einer Spezies X gebildet wird, die die Dissoziation der hydrierten Spezies zum Bilden der Ionen auf Wasserstoffbasis fördert, wobei die mindestens eine Spezies X aus Argon, Stickstoff, Xenon und Helium ausgewählt wird.

10. Verfahren nach einem der vorstehenden Ansprüche, wobei die Ionen auf Wasserstoffbasis mit einer Implantationsenergie größer als 150 eV und/oder kleiner als 300 eV implantiert werden.

11. Verfahren nach einem der vorstehenden Ansprüche, wobei nach der anisotropen Modifikation durch Implantation das Halbleitermaterial der aktiven Schicht (13) eine Wasserstoffkonzentration [H]a1 aufweist, wobei das Tempern derart erfolgt, dass nach dem Tempern die Wasserstoffkonzentration [H]a2 gleich null oder kleiner als 0,05 * [H]a1 und bevorzugt kleiner als 0,02 * [H]a1 ist.

12. Verfahren nach einem der vorstehenden Ansprüche, wobei die anisotrope Modifikation durch Implantation in einem Ätzreaktor durchgeführt wird.

13. Verfahren nach einem der vorstehenden Ansprüche, wobei das Tempern dazu konfiguriert ist, mindestens 90 % der Spezies auf Wasserstoffbasis, die in den ersten modifizierten Basisteilen (31b) implantiert sind, zu desorbieren.

14. Verfahren nach einem der vorstehenden Ansprüche, wobei das Tempern dazu konfiguriert ist, mindestens 95 % der Spezies auf Wasserstoffbasis, die in den ersten modifizierten Basisteilen (31b) implantiert sind, zu desorbieren.

## Claims

1. Method for forming at least one spacer (E) of a gate (20) of a transistor located on an active layer (13) made of a semiconductive material, comprising:
- a supply of a stack comprising the active layer (13) and the gate (20), said gate (20) having a top (21) and lateral sides (22),
- a formation of a dielectric layer (3) made of a dielectric base material covering the gate and at least partially the active layer (13) on either side of the gate (20), said dielectric layer (3) having lateral portions (30l) covering the lateral sides (22) of the gate, and basal portions (30b) covering the top (21) and the active layer (13), the basal portions (30b) having a thickness eb,
- an anisotropic modification of the basal portions (30b) of said dielectric layer (3) by implantation of hydrogen-based ions in a direction (Z) parallel to the lateral sides (22) of the gate (20), said implantation being performed along the whole thickness eb of the basal portions (30b), and at least partially in the active layer (13, 13m), said anisotropic modification forming first modified basal portions (31b) based on a first modified dielectric material and non-modified lateral portions (30l) based on the dielectric base material, then
- an annealing configured to desorb the hydrogen-based species implanted in the active layer (13, 13m) and at least 75% of the hydrogen-based species implanted in the first modified basal portions (31b), said annealing transforming the first modified basal portions (31b) into second modified basal portions (32b) based on a second modified dielectric material, then
- an annealing of the second modified basal portions (32b) by selective etching of the second modified dielectric material with respect to the dielectric base material and with respect to the semiconductive material, so as to form the at least one spacer (E) on the lateral sides (22) of the gate from non-modified lateral portions (30l).

2. Method according to the preceding claim, wherein the dielectric base material is chosen such that the second modified dielectric material has a selectivity at the etching S ≥ 5:1 with respect to said dielectric base material, and preferably S ≥ 10:1.

3. Method according to any one of the preceding claims, wherein the dielectric base material is SiC-based.

4. Method according to any one of the preceding claims, wherein, before the anisotropic modification by implantation of hydrogen-based ions, the dielectric base material is SiCO-based and, upon completion of the anisotropic modification by implantation of hydrogen-based ions, the first modified dielectric material is SiOxHy-based, and, upon completion of the annealing, the second modified dielectric material is SiOx-based, x and y being natural, non-zero integers.

5. Method according to any one of the preceding claims, wherein the annealing is performed at a temperature greater than or equal to 150°C or at a temperature greater than or equal to 600°C.

6. Method according to any one of the preceding claims, wherein the annealing is performed for a duration t of between 1 min ≤ t ≤ 10 min.

7. Method according to any one of the preceding claims, wherein the removal of the second modified basal portions (32b) is done by wet etching based on a solution comprising hydrofluoric (HF) acid.

8. Method according to any one of the preceding claims, wherein the anisotropic modification is performed by inductive coupled plasma from a hydrogenated species, preferably taken from among dihydrogen (H2), hydrogen bromide (HBr) and ammoniac (NH3).

9. Method according to the preceding claim, wherein the plasma is formed by using at least one species X favouring the dissociation of the hydrogenated species to form said hydrogen-based ions, said at least one species X being taken from among argon, nitrogen, xenon, helium.

10. Method according to any one of the preceding claims, wherein the hydrogen-based ions are implanted with an implantation energy greater than 150eV and/or less than 300eV.

11. Method according to any one of the preceding claims, wherein upon completion of the anisotropic modification by implantation, the semiconductive material of the active layer (13) has a hydrogen concentration [H]a1, the annealing being performed such that upon completion of the annealing, the hydrogen concentration [H]a2 is zero or less than 0.05 * [H]a1, and preferably less than 0.02 * [H]a1.

12. Method according to any one of the preceding claims, wherein the anisotropic modification by implantation is performed in an etching reactor.

13. Method according to any one of the preceding claims, wherein the annealing is configured to desorb at least 90% of the hydrogen-based species implanted in the first modified basal portions (31b).

14. Method according to any one of the preceding claims, wherein the annealing is configured to desorb at least 95% of the hydrogen-based species implanted in the first modified basal portions (31b).
